# EUROPÄISCHE PATENTSCHRIFT

(11) **EP 4 029 185 B1**
(45) Veröffentlichungstag und Bekanntmachung des Hinweises auf die Patenterteilung: **22.11.2023**
(21) Anmeldenummer: 20740605.9
(22) Anmeldetag: 14.07.2020
(51) Int. Cl.: H04L 7/00, H04L 25/02, G08C 19/28, G05B 19/18

(54) **VORRICHTUNG UND VERFAHREN ZUR SYNCHRON-SERIELLEN DATENÜBERTRAGUNG**
DEVICE AND METHOD FOR SYNCHRONOUS-SERIAL DATA TRANSMISSION
DISPOSITIF ET PROCÉDÉ DE TRANSMISSION SYNCHRONE ET SÉRIELLE DE DONNÉES

(30) Priorität: 13.09.2019 DE 102019213982
(43) Veröffentlichungstag der Anmeldung: 20.07.2022
(73) Patentinhaber: Dr. Johannes Heidenhain GmbH, 83301 Traunreut (DE)
(72) Erfinder: HUBER, Manfred, 83349 Palling (DE)
(86) Internationale Anmeldenummer: PCT/EP2020/069838
(87) Internationale Veröffentlichungsnummer: WO 2021/047807

(56) Entgegenhaltungen:
- EP-A1- 0 171 579
- EP-A1- 0 660 209
- WO-A1-96/35159
- WO-A1-2013/020529
- WO-A1-2017/183508
- DE-A1- 19 919 140

## Beschreibung

### GEBIET DER TECHNIK

Die vorliegende Erfindung betrifft eine Vorrichtung und ein Verfahren zur synchron-seriellen Datenübertragung gemäß Anspruch 1, bzw. 6. Weiter betrifft die Erfindung eine Folgeelektronik nach Anspruch 11. Sie ist besonders vorteilhaft bei Anwendungen in der Automatisierungstechnik, weil hier häufig Datenübertragungen über lange Leitungen notwendig sind.

### STAND DER TECHNIK

In der Automatisierungstechnik werden häufig Messgeräte eingesetzt, die digitale Messwerte zur Verfügung stellen. Im Bereich der numerischen Steuerungen, die beispielsweise zur Steuerung von Werkzeugmaschinen eingesetzt werden, gilt das besonders für Positionsmessgeräte zur Messung von linearen oder rotatorischen Bewegungen. Positionsmessgeräte, die digitale (absolute) Messwerte generieren, werden als absolute Positionsmessgeräte bezeichnet.

Für die Übertragung der absoluten Positionswerte und sonstiger Daten kommen hauptsächlich serielle Datenschnittstellen zum Einsatz, da diese mit nur wenigen Datenübertragungsleitungen auskommen und trotzdem hohe Datenübertragungsraten aufweisen. Da die Datenübertragung meist über große Kabellängen erfolgt, werden die Schnittstellensignale differentiell übertragen, beispielsweise nach dem RS-485-Standard. Senderseitig werden hierzu massebezogene Digitalsignale mittels spezieller Treiberbausteine in Differenzsignale umgewandelt und ausgegeben, empfängerseitig werden die übertragenen Signale in Empfängerbausteinen für die weitere Verarbeitung wieder zurückgewandelt. Die Übertragung erfolgt über Leitungspaare, deren Leitungen miteinander verdrillt sind.

Besonders vorteilhaft sind die sogenannten synchron-seriellen Schnittstellen, die ein uni- oder bidirektional betriebenes Datenleitungspaar und ein Taktleitungspaar aufweisen. Die Übertragung von Datenpaketen über das Datenleitungspaar erfolgt synchron zu einem Taktsignal auf dem Taktleitungspaar. In der Automatisierungstechnik hat sich eine Vielzahl von derartigen digitalen Standardschnittstellen durchgesetzt, populäre Vertreter für synchron-serielle Schnittstellen sind beispielsweise die EnDat-Schnittstelle der Anmelderin, eine weitere ist unter der Bezeichnungen SSI bekannt.

Die SSI-Schnittstelle wird in der EP 0 171 579 A1 beschrieben. Es handelt sich hierbei um eine synchron-serielle Datenschnittstelle mit einem unidirektional betriebenen Daten- und einem unidirektional betriebenen Taktleitungspaar. Das Auslesen von Positionswerten von einem Positionsmessgerät erfolgt hier synchron zu einem Taktsignal, das über das Taktleitungspaar übertragen wird.

Die EP 0 660 209 A1 beschreibt dagegen die Grundlage der EnDat-Schnittstelle der Anmelderin. Bei dieser handelt es sich ebenfalls um eine synchron-serielle Schnittstelle, die jedoch neben dem unidirektional betriebenen Taktleitungspaar ein bidirektional betriebenes Datenleitungspaar aufweist. Dadurch ist eine Übertragung von Daten in beide Richtungen - von einer Folgeelektronik (z.B. einer numerischen Steuerung) zum Positionsmessgerät und vom Positionsmessgerät zur Folgeelektronik - möglich. Die Datenübertragung erfolgt auch hier synchron zu einem Taktsignal.

Die für die Übertragung verwendeten Leitungspaare haben, neben dem ohmschen Widerstand, sowohl kapazitive, als auch induktive Eigenschaften, die von der Leitungslänge abhängen. In der Übertragungstechnik spricht man in diesem Zusammenhang von einem Kapazitätsbelag und einem Induktivitätsbelag der Leitung. Die hieraus bei der Datenübertragung resultierenden Umladevorgänge führen zu einer Verformung der übertragenen Signale. Daher ist die maximal erreichbare Kabellänge für eine sichere Übertragung, eine konstante Datenrate vorausgesetzt, bestimmt durch die Fähigkeit der empfängerseitigen Differenzempfänger, aus den empfangenen Signalen das ursprünglich gesendete Digitalsignal wiederherzustellen.

### ZUSAMMENFASSUNG DER ERFINDUNG

Es ist eine Aufgabe der vorliegenden Erfindung, eine Vorrichtung zur Erhöhung der maximalen Leitungslänge bei synchron-seriellen Schnittstellen zu schaffen.

Diese Aufgabe wird gelöst durch eine Vorrichtung nach Anspruch 1.

Es wird eine Vorrichtung zur synchron-seriellen Datenübertragung über einen differentiellen Datenkanal und einen differentiellen Taktkanal vorgeschlagen, aufweisend einen Schnittstellencontroller mit einem Taktgenerator und einem Datencontroller, sowie einen Takt-Sendebaustein und einen Daten-Empfängerbaustein, wobei
- vom Taktgenerator ein Sendetaktsignal erzeugbar ist, das während eines Datenübertragungszyklus eine Taktpulsfolge mit einer Periodendauer umfasst,
- das Sendetaktsignal dem Takt-Sendebaustein zugeführt ist, der es zur Ausgabe über den Taktkanal in ein differentielles Taktsignal wandelt,
- ein über den differentiellen Datenkanal eintreffendes differentielles Datensignal dem Daten-Empfängerbaustein zugeführt ist, der es in ein Datensignal wandelt und dem Datencontroller zuführt und
- das Sendetaktsignal dem Datencontroller zur Synchronisation des Einlesens des Datensignals zugeführt ist.

Erfindungsgemäß ist der Taktgenerator geeignet ausgestaltet, bei Datenübertragungszyklen in einem dynamischen Betriebszustand, bei dem die größte auftretende Differenzspannung des differentiellen Taktsignals kleiner ist als die maximale Differenzspannung des Takt-Sendebausteins, die Dauer der ersten Taktphase der ersten Taktperiode der Taktpulsfolge länger als die erste Taktphase der folgenden Taktperioden und kürzer als eine zum Erreichen der maximalen Differenzspannung notwendige Zeitdauer einzustellen.

Weiter ist es Aufgabe der vorliegenden Erfindung, ein Verfahren zur Erhöhung der maximalen Leitungslänge bei synchron-seriellen Schnittstellen zu schaffen.

Diese Aufgabe wird gelöst durch ein Verfahren nach Anspruch 6.

Es wird ein Verfahren zur synchron-seriellen Datenübertragung über einen differentiellen Datenkanal und einen differentiellen Taktkanal mit einer Vorrichtung, aufweisend einen Schnittstellencontroller mit einem Taktgenerator und einem Datencontroller, sowie einen Takt-Sendebaustein und einen Daten-Empfängerbaustein, vorgeschlagen, wobei
- vom Taktgenerator ein Sendetaktsignal erzeugt wird, das während eines Datenübertragungszyklus eine Taktpulsfolge mit einer Periodendauer umfasst,
- das Sendetaktsignal dem Takt-Sendebaustein zugeführt wird, der es zur Ausgabe über den Taktkanal in ein differentielles Taktsignal wandelt,
- ein über den differentiellen Datenkanal eintreffendes differentielles Datensignal dem Daten-Empfängerbaustein zugeführt wird, der es in ein Datensignal wandelt und dem Datencontroller zuführt und
- das Sendetaktsignal dem Datencontroller zur Synchronisation des Einlesens des Datensignals zugeführt wird.

Gemäß der Erfindung ist der Taktgenerator (44) geeignet ausgestaltet, bei Datenübertragungszyklen in einem dynamischen Betriebszustand (DYN), bei dem die größte auftretende Differenzspannung des differentiellen Taktsignals (C+, C-) kleiner ist als die maximale Differenzspannung (UDmax) des Takt-Sendebausteins (50), die Dauer der ersten Taktphase (TH1) der ersten Taktperiode (T1) der Taktpulsfolge (TP) länger als die erste Taktphase (TH) der folgenden Taktperioden und kürzer als eine zum Erreichen der maximalen Differenzspannung (UDmax) notwendige Zeitdauer einzustellen.

Weitere Vorteile und Ausgestaltungen ergeben sich aus den abhängigen Ansprüchen und aus der Beschreibung der Ausführungsbeispiele.

### KURZE BESCHREIBUNG DER ZEICHNUNGEN

Es zeigt
- Figur 1: ein Blockdiagramm einer erfindungsgemäßen Vorrichtung in einer Folgeelektronik,
- Figur 2: ein vereinfachtes Signaldiagramm der Übertragung des Sendetaktsignals bei großer Leitungslänge L nach dem Stand der Technik,
- Figur 3: ein vereinfachtes Signaldiagramm einer erfindungsgemäßen Übertragung des Sendetaktsignals CLK_S bei großer Leitungslänge L,
- Figur 4a: ein Blockdiagramm einer ersten Ausführungsform eines erfindungsgemäßen Taktgenerators,
- Figur 4b: ein Blockdiagramm einer weiteren Ausführungsform eines erfindungsgemäßen Taktgenerators und
- Figur 4c: ein Blockdiagramm einer weiteren Ausführungsform eines erfindungsgemäßen Taktgenerators.

### BESCHREIBUNG DER AUSFÜHRUNGSFORMEN

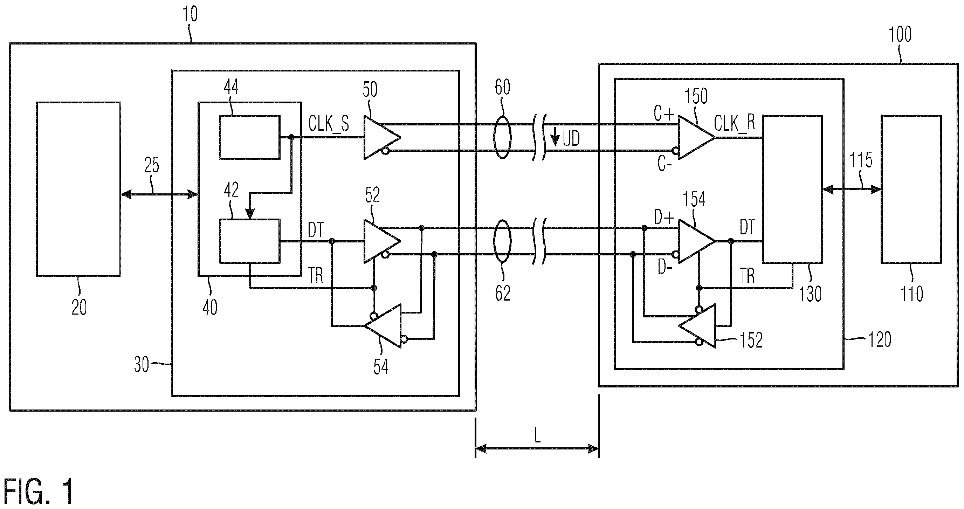

Figur 1 zeigt ein Blockdiagramm einer Folgeelektronik 10, die mittels einer Schnittstellenverbindung, die einen Taktkanal 60 und einen Datenkanal 62 umfasst, zum Zwecke der Datenübertragung mit einer Positionsmesseinrichtung 100 verbunden ist. Zur Steuerung der Datenübertragung ist seitens der Folgeelektronik 10 eine Master-Schnittstelle 30 vorgesehen, die eine erfindungsgemäße Vorrichtung bildet und die mit einer Slave-Schnittstelle 120 der Positionsmesseinrichtung 100 kommuniziert. Die Master-Schnittstelle 30 ist als synchron-serielle Schnittstelle ausgeführt, wobei die Signalübertragung differentiell erfolgt, beispielsweise nach dem RS-485-Standard. Demgemäß weisen der Taktkanal 60 und der Datenkanal 62 je ein Leitungspaar auf.

Die Folgeelektronik 10 ist ein Gerät der Automatisierungstechnik, beispielsweise eine numerische Werkzeugmaschinensteuerung, eine Steuerung eines Fertigungsroboters, eine Positionsanzeige, oder eine sonstige Anlagensteuerung. Sie weist eine programmgesteuerte zentrale Steuerungseinheit 20 auf, die als Computer ausgeführt ist. Sie umfasst somit wenigstens einen Mikroprozessor oder Mikrocontroller, Speichereinheiten und kann diverse weitere Schnittstellen, beispielsweise zum Anschluss von Peripheriegeräten (Tastatur, Maus, Monitor etc.), umfassen. Der Steuerungseinheit 20 können Leistungseinheiten, beispielsweise zur Ansteuerung von Elektromotoren, zugeordnet sein. Neben der dargestellten Master-Schnittstelle 30 können selbstverständlich noch weitere erfindungsgemäße Master-Schnittstellen für den Anschluss weiterer Positionsmesseinrichtungen vorgesehen sein.

Die Positionsmesseinrichtung 100 kann als Drehgeber, Winkelmessgerät, Längenmessgerät, Messtaster oder sonstiges Positionsmessgerät ausgeführt sein, das absolute Positionswerte generiert. Sie weist eine Positionserfassungseinheit 110 auf, die geeignet ausgestaltet ist, um durch Abtastung einer Messteilung mit einer Abtastvorrichtung positionsabhängige Signale zu generieren, aus diesen absolute Positionswerte zu ermitteln und auf eine Anforderung der Master-Schnittstelle 30 über die Slave-Schnittstelle 120 zur Folgeelektronik 10 zu übertragen. Darüber hinaus können in der Positionsmesseinrichtung 100 Speicher vorgesehen sein, in denen weitere Daten speicherbar sind. Die Übertragung weiterer Daten von und zu der Folgeelektronik 10 kann ebenfalls über die Slave-Schnittstelle 120 erfolgen.

Die Master-Schnittstelle 30 umfasst einen Schnittstellencontroller 40 mit einem Taktgenerator 44 und einem Datencontroller 42, sowie einen Takt-Sendebaustein 50, einen (optionalen) Daten-Sendebaustein 52 und einen Daten-Empfängerbaustein 54.

Der Schnittstellencontroller 40 der Master-Schnittstelle 30 ist durch eine interne Schnittstelle 25 mit der Steuerungseinheit 20 verbunden. Die interne Schnittstelle 25 erlaubt eine Kommunikation zwischen der Steuerungseinheit 20 und dem Schnittstellencontroller 40. So sind Befehle und ggf. Daten, die von der Steuerungseinheit 20 an die Positionsmesseinrichtung 100 gesendet werden sollen, an den Schnittstellencontroller 40 übertragbar. Daten, die von der Positionsmesseinrichtung 100 bei der Master-Schnittstelle 30 eintreffen, können vom Schnittstellencontroller 40 über die interne Schnittstelle 25 zur weiteren Verarbeitung an die Steuerungseinheit 20 weitergeleitet werden. Die Kommunikation der Master-Schnittstelle 30 über den Taktkanal 60 und den Datenkanal 62 wird somit von der Steuerungseinheit 20 über die interne Schnittstelle 25 gesteuert.

Der Taktgenerator 44 generiert ein Sendetaktsignal CLK_S, das zum einen zur Positionsmesseinrichtung 100 übertragen wird und zum anderen dem Datencontroller 42 zugeführt ist. Zwischen zwei Datenübertragungszyklen weist das Sendetaktsignal CLK_S einen konstanten Pegel auf, während eines Datenübertragungszyklus gibt der Taktgenerator 44 über das Sendetaktsignal CLK_S eine Taktpulsfolge aus.

Der Datencontroller 42 ist zum einen geeignet ausgestaltet, um Befehle und ggf. Daten zur Positionsmesseinrichtung 100 zu übertragen, zum anderen um Daten von der Positionsmesseinrichtung 100 zu empfangen. Die Ausgabe, bzw. das Einlesen des bidirektionalen Datensignals DT erfolgt seriell und synchron zum Sendetaktsignal CLK_S.

Für die Übertragung des Sendetaktsignals CLK_S über den Taktkanal 60 ist das Sendetaktsignal CLK_S einem Takt-Sendebaustein 50 zugeführt, der das massebezogene (single-ended) Signal in ein differentielles Taktsignal, bestehend aus einem nicht-invertierten Taktsignal C+ und einem invertierten Taktsignal C-, umwandelt. Ein derartiger Baustein wird auch als Differenz-Treiber bezeichnet.

Für die Ausgabe des (ebenfalls massebezogenen) Datensignals DT ist dieses einem Daten-Sendebaustein 52 zugeführt, der hieraus ein differentielles Datensignal, umfassend ein nicht-invertiertes Datensignal D+ und ein invertiertes Datensignal D- erzeugt. Für den Empfang von Daten ist das differentielle Datensignal D+, D- einem Daten-Empfängerbaustein 54 (Differenz-Empfänger) zugeführt, der hieraus wieder ein massebezogenes digitales Datensignal DT generiert. Um Signalkollisionen zu vermeiden, ist ein Datenrichtungssignal TR vorgesehen, mit dem der Datencontroller 42 den jeweiligen Baustein (Daten-Empfängerbaustein 54 oder Daten-Sendebaustein 52) aktiv, bzw. hochohmig schaltet. Wann welcher Baustein aktiv zu schalten ist, ist in einem Schnittstellenprotokoll definiert.

Seitens der Positionsmesseinrichtung 100 ist das differentielle Taktsignal C+, C- einem Takt-Empfängerbaustein 150 zugeführt, der dieses wieder in ein massebezogenes Signal zurückwandelt, das als Empfänger-Taktsignal CLK_R einem zum Schnittstellencontroller 40 der Folgeelektronik korrespondierenden Schnittstellencontroller 130 zur Synchronisation der Dateneingabe bzw. -ausgabe zugeführt ist. Das differentielle Datensignal D+, D- ist zum einen einem Daten-Empfängerbaustein 154 zugeführt, der dieses in ein massebezogenes Datensignal DT zurückwandelt und dem Schnittstellencontroller 130 zuführt, zum anderen ist ein Daten-Sendebaustein 152 vorgesehen, der in entgegengesetzter Datenrichtung das auszugebende Datensignal DT für die Übertragung zur Folgeelektronik 10 in das differentielle Datensignal D+, D- umwandelt. Auch hier wird die Datenrichtung durch ein Datenrichtungssignal TR eingestellt, das gemäß dem Schnittstellenprotokoll geschaltet wird.

Datenanforderungsbefehle der Folgeelektronik 10, die bei der Slave-Schnittstelle 120 eintreffen, werden wiederum über eine interne Schnittstelle 115 der Positionserfassungseinheit 110 zugeführt, diese stellt die angeforderten Daten bereit und leitet sie an die Slave-Schnittstelle 120 weiter. Eintreffende Daten werden ebenfalls über die interne Schnittstelle 120 zur Positionserfassungseinheit 110 weitergeleitet und dort verarbeitet bzw. gespeichert.

Die dargestellte Positionsmesseinrichtung 100 ist damit zur Durchführung einer bidirektionalen Datenübertragung gemäß der EP 0 660 209 A1 geeignet.

Alternativ kann die Positionsmesseinrichtung 100 auch entsprechend der EP 0 171 579 A1 ausgeführt sein. In diesem Fall kann auf den Daten-Empfängerbaustein 154 (und dem korrespondierenden Daten-Sendebaustein 52 der Folgeelektronik) verzichtet werden, so dass die Datenübertragung unidirektional erfolgt.

Der Taktkanal 60 ist in beiden Fällen unidirektional, d.h. das Taktsignal CLK_S wird von der Master-Schnittstelle 30 zur Slave-Schnittstelle 120 übertragen. Entsprechend dem Grundprinzip synchron-serieller Datenübertragung erfolgt die Synchronisation der seriell übertragenen Datenbits auf dem Datenkanal 62 über das über den Taktkanal 60 übertragene Sendetaktsignal CLK_S, wobei während eines Datenübertragungszyklus je Taktperiode der über das Sendetaktsignal CLK_S ausgegebenen Taktpulsfolge ein Datenbit übertragen, bzw. gelesen wird. Dies hat für die weiteren Betrachtungen die Konsequenz, dass nur die Frequenz der Taktpulsfolge der begrenzende Faktor für eine erreichbare Leitungslänge L zwischen der Folgeelektronik 10 und der Positionsmesseinrichtung 100 ist, da die höchste Frequenz, die im Datensignal DT auftreten kann, lediglich der halben Taktfrequenz des Sendetaktsignals CLK_S entspricht. In anderen Worten ausgedrückt, solange die Übertragungsstrecken (Differenz-Treiber, Leitungspaare, Differenz-Empfänger) des Sendetaktsignals CLK_S und des Datensignals DT weitgehend gleiche Eigenschaften aufweisen, kann von einer sicheren Datenübertragung ausgegangen werden, wenn empfängerseitig (seitens der Positionsmesseinrichtung 100) die Taktpulsfolge des Sendetaktsignal CLK_S (als Empfängertaktsignal CLK_R) wiederhergestellt werden kann.

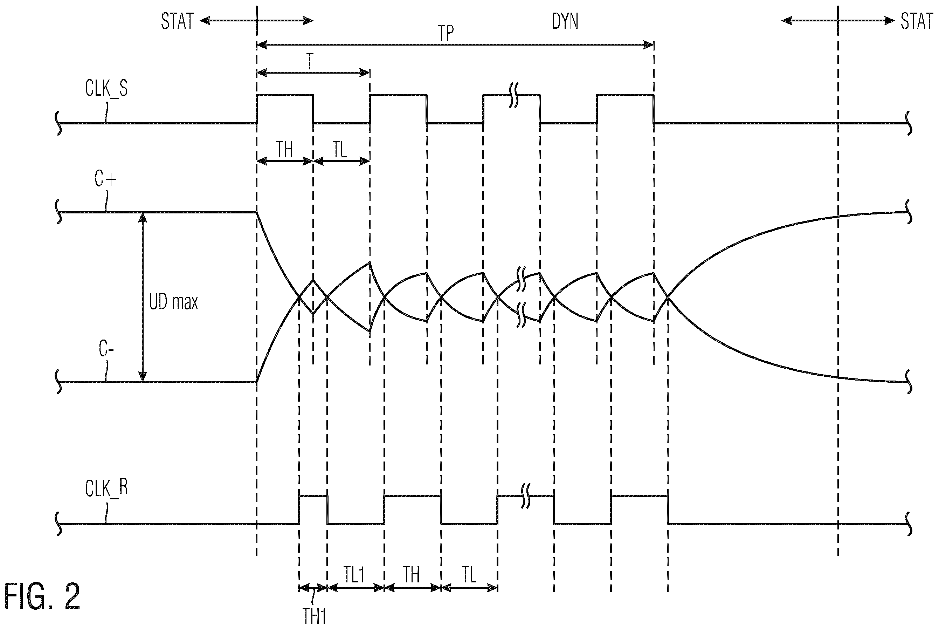

Figur 2 zeigt ein vereinfachtes Signaldiagramm der Übertragung des Sendetaktsignals CLK_S von der Folgeelektronik 10 zur Positionsmesseinrichtung 100 bei großer Leitungslänge L nach dem Stand der Technik. Es sei darauf hingewiesen, dass die zeitliche Verzögerung des in der Positionsmesseinrichtung 100 rekonstruierten Empfängertaktsignals CLK_R, die sich aus der Leitungslänge L ergibt, nicht dargestellt ist. Gezeigt wird nur der Einfluss der differentiellen Übertragung und Rekonstruktion seitens der Positionsmesseinrichtung 100.

Die in einem herkömmlichen Taktgenerator für die Dauer einer Datenübertragung erzeugte Taktpulsfolge des Sendetaktsignals CLK_S weist eine konstante Frequenz auf, die durch die Periodendauer T bestimmt ist. Die Taktperioden sind symmetrisch, d.h. die High-Phase TH und die Low-Phase TL jeder Periode sind gleich lang, ihre Zeitdauer entspricht T/2.

In Zeiten, zu denen keine Datenübertragung stattfindet, weist das Sendetaktsignal CLK_S einen konstanten logischen Pegel auf, im dargestellten Beispiel einen Low-Pegel. Als Konsequenz daraus zeigt das differentielle Taktsignal C+, C- eine maximale Differenzspannung UDmax. Das hieraus in der Positionsmesseinrichtung 100 wiederhergestellte Empfängertaktsignal CLK_R weist ebenfalls einen konstanten logischen Low-Pegel auf. Der Taktkanal 60 befindet sich somit in einem statischen Betriebszustand STAT. Zu Zeiten, in denen eine Taktpulsfolge übertragen wird, also eine Datenübertragung stattfindet, wird bei großen Leitungslängen L in den Phasen der Signalperioden der Taktpulsfolge die maximale Differenzspannung UDmax nicht mehr erreicht, d.h. die Umladevorgänge des Leitungspaars des Taktkanals 60 gehen ineinander über. Erst nach dem Datenübertragungszyklus, wenn das Taktsignal CLK_S wieder einen statischen Pegel einnimmt, wird das Leitungspaar wieder bis zur maximalen Differenzspannung UDmax geladen. Ab dem Zeitpunkt, zu dem der erste Taktpuls für eine Datenübertragung ausgegeben wird, bis nach der Datenübertragung der statische Betriebszustand STAT wieder erreicht wird, befindet sich der Taktkanal 60 in einem dynamischen Betriebszustand DYN.

Dem Empfängertaktsignal CLK_R, das der Takt-Empfängerbaustein 150 aus dem nicht-invertierten Taktsignal C+ und dem invertierten Taktsignal C-rekonstruiert, ist zu entnehmen, dass durch die höhere Differenzspannung, die beim ersten Puls (im dargestellten Beispiel der ersten High-Phase TH1) der Taktfolge einer Datenübertragung umgeladen werden muss, um einen Pegelwechsel des Empfängertaktsignals CLK_R zu erreichen, die Pulsdauer des rekonstruierten ersten Pulses (der ersten High-Phase TH1) verkürzt wird. Durch die daraus resultierende kleinere Differenzspannung am Ende des ersten Pulses ergibt sich noch eine geringfügige Verlängerung der ersten Low-Phase TL1 des rekonstruierten Signals, die weiteren Pulse entsprechen weitgehend der Taktpulsfolge des Sendetaktsignals CLK_S.

Die Verkürzung der ersten High-Phase TH1 des Empfängertaktsignals CLK_R führt dazu, dass das Taktsignal nicht mehr korrekt auswertbar ist, so dass ein Fehler in der Datenübertragung entsteht.

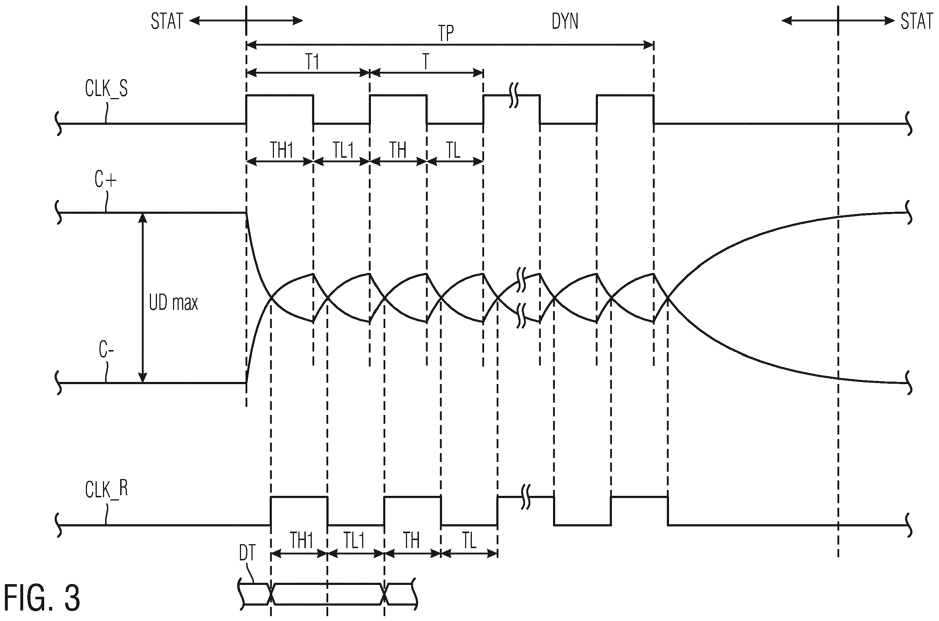

Figur 3 zeigt ein vereinfachtes Signaldiagramm der Übertragung eines gemäß der vorliegenden Erfindung gebildeten Sendetaktsignals CLK_S von der Folgeelektronik 10 zur Positionsmesseinrichtung 100 bei großer Leitungslänge L. Der Datenübertragungszyklus erfolgt im dynamischen Betriebszustand DYN, d.h. die maximale Differenzspannung UDmax des differentiellen Taktsignals C+, C- wird nicht erreicht. Zur Erzeugung des Sendetaktsignals CLK_S ist der Taktgenerator 44 nun erfindungsgemäß ausgestaltet, die Zeitdauer der ersten Taktphase der ersten Taktperiode T1 der Taktpulsfolge TP des Datenübertragungszyklus, im dargestellten Beispiel die erste High-Phase TH1, soweit zu verlängern, so dass seitens der Positionsmesseinrichtung 100 die korrespondierende Taktphase (die High-Phase TH1) der ersten Taktperiode T1 der rekonstruierten Taktpulsfolge wieder auswertbar ist. Andererseits darf die Zeitdauer der ersten Taktphase (die erste High-Phase TH1) aber auch nicht soweit verlängert werden, dass das differentielle Taktsignal C+, C- die maximale Differenzspannung UDmax erreicht.

Diese Lösung basiert auf der Erkenntnis, dass, sofern die Frequenz der Taktimpulsfolge TP des Sendetaktsignals CLK_S unverändert bleibt, bei einer Erhöhung der Leitungslänge L lediglich aus der ersten Taktphase der Taktpulsfolge ein Fehler resultiert, während alle weiteren Taktphasen empfängerseitig (also seitens der Positionsmesseinrichtung 100) korrekt wiederhergestellt werden können.

Das Senden und Empfangen des Datensignals DT, sowohl seitens der Folgeelektronik 10, als auch seitens der Positionsmesseinrichtung 100 erfolgt weiter synchron zu zugeordneten Taktflanken des Sendetaktsignals CLK_S, bzw. Empfängertaktsignals CLK_R. Eine Anpassung des Datencontrollers 42 (und ggf. des Schnittstellencontrollers 130) ist daher nicht nötig. In Figur 3 ist das Datensignal DT deshalb nur angedeutet. Im dargestellten Fall erfolgt die Abtastung des Datensignals DT bei der fallenden Flanke des Empfängertaktsignals CLK_R.

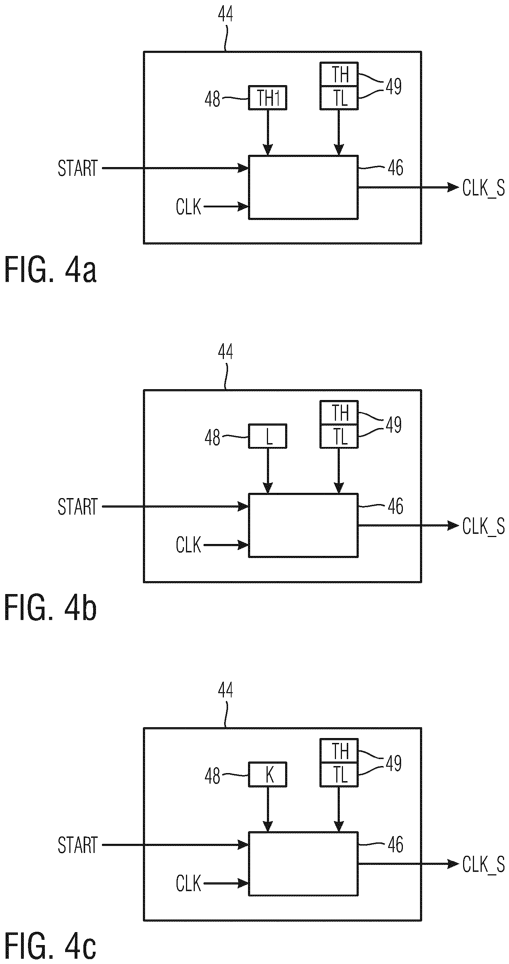

Figur 4a zeigt ein Blockdiagramm einer ersten Ausführungsform eines erfindungsgemäßen Taktgenerators 44. Er weist eine Takt-Ausgabeeinheit 46, sowie wenigstens ein Register 48 auf.

Die Takt-Ausgabeeinheit 46 ist geeignet ausgestaltet, um das Sendetaktsignal CLK_S auszugeben. Im Register 48 ist hierzu die Dauer der ersten Taktphase (der ersten High-Phase TH1) einer Taktpulsfolge TP gespeichert. In wenigstens einem weiteren Register 49 kann eine Information über die regulären Taktpulse der Taktpulsfolge TP gespeichert sein, z.B. die Dauer der High-Phase TH und der Low-Phase TL, oder, bei symmetrischem Taktsignal, der Periodendauer T. Der Takt-Ausgabeeinheit 46 ist ein Arbeitstaktsignal CLK zugeführt, das als Zeitbasis zur Erzeugung der Taktpulsfolge TP dient, sowie ein Startsignal START, das die Ausgabe der Taktpulsfolge TP initiiert.

Für die Erzeugung der Taktpulsfolge TP kann in der Takt-Ausgabeeinheit 46 beispielsweise ein Zähler vorgesehen sein, der im Zeitraster des Arbeitstaktsignals CLK zählt und jeweils für die Dauer der in den Registern 48, 49 gespeicherten Werte die geforderten logischen Pegel ausgibt.

Mit Vorteil kann der Wert des Registers 48 von der Steuerungseinheit 20 der Folgeelektronik 10 geschrieben werden. Auf diese Weise ist eine Anpassung an verschiedene Leitungslängen L, Kabelspezifikationen, Frequenzen des Sendetaktsignals CLK_S, etc. möglich.

Die Ermittlung der Dauer der ersten Taktphase kann durch Berechnung, Messung oder schrittweise Annäherung (Iterationsverfahren) erfolgen.

Figur 4b zeigt ein Blockdiagramm einer alternativen Ausführungsform eines erfindungsgemäßen Taktgenerators 44. Hier wird in das Register 48 die Leitungslänge L eingetragen und die Takt-Ausgabeeinheit 46 ermittelt die benötigte Dauer der ersten Taktphase durch Berechnung oder durch Auswahl aus einer Tabelle, deren Werte mit Vorteil bereits herstellerseitig ermittelt und gespeichert werden. Bei variabler Taktfrequenz des Sendetaktsignals CLK_S kann diese ebenfalls berücksichtigt werden, beispielsweise indem die Dauer der High-Phase TH und/oder der Low-Phase TL, oder die Periodendauer T in den weiteren Registern 49 gespeichert und der Takt-Ausgabeeinheit 46 zugeführt sind.

Figur 4c zeigt ein Blockdiagramm einer weiteren alternativen Ausführungsform eines erfindungsgemäßen Taktgenerators 44. Hier ist im Register 48 lediglich eine Konstante K gespeichert, anhand derer die Takt-Ausgabeeinheit 46 die Dauer der ersten Taktphase TH 1 des Sendetaktsignals CLK_S einstellt. Hierbei kann es sich um einen Multiplikator handeln, der die Verlängerung der ersten Taktphase TH1 ausgehend von einer regulären Taktphase TH festlegt, so dass gilt: TH1 = K * TH. Die Konstante K ist so gewählt, dass für wenigstens eine Frequenz der Taktimpulsfolge TP des Sendetaktsignals CLK_S bis zu einer definierten maximalen Leitungslänge eine fehlerfreie Übertragung ermöglicht wird, wobei die maximale Leitungslänge länger ist als die erreichbare Leitungslänge bei einer Master-Schnittstelle 30 ohne die erfindungsgemäße Verbesserung. Ein bewährter Wert für die erste Taktphase, um eine im Vergleich zum Stand der Technik größere Leitungslänge L zu erreichen, ist die doppelte Dauer einer regulären Taktphase TH des Sendetaktsignals CLK_S. Ist die erste Taktphase die in Figur 3 dargestellte High-Phase TH1, so gilt: TH1 = 2 * TH.

## Patentansprüche

1. Vorrichtung (30) zur synchron-seriellen Datenübertragung über einen differentiellen Datenkanal (62) und einen differentiellen Taktkanal (60), aufweisend einen Schnittstellencontroller (40) mit einem Taktgenerator (44) und einem Datencontroller (42), sowie einen Takt-Sendebaustein (50) und einen Daten-Empfängerbaustein (54), wobei
- vom Taktgenerator (44) ein Sendetaktsignal (CLK_S) erzeugbar ist, das während eines Datenübertragungszyklus eine Taktpulsfolge (TP) mit einer Periodendauer (T) umfasst,
- das Sendetaktsignal (CLK_S) dem Takt-Sendebaustein (50) zugeführt ist, der es zur Ausgabe über den Taktkanal (60) in ein differentielles Taktsignal (C+, C-) wandelt,
- ein über den differentiellen Datenkanal (62) eintreffendes differentielles Datensignal (D+, D-) dem Daten-Empfängerbaustein (54) zugeführt ist, der es in ein Datensignal (DT) wandelt und dem Datencontroller (42) zuführt,
- das Sendetaktsignal (CLK_S) dem Datencontroller (42) zur Synchronisation des Einlesens des Datensignals (DT) zugeführt ist,
**dadurch gekennzeichnet, dass** der Taktgenerator (44) geeignet ausgestaltet ist, bei Datenübertragungszyklen in einem dynamischen Betriebszustand (DYN), bei dem die größte auftretende Differenzspannung des differentiellen Taktsignals (C+, C-) kleiner ist als die maximale Differenzspannung (UDmax) des Takt-Sendebausteins (50), die Dauer der ersten Taktphase (TH1) der ersten Taktperiode (T1) der Taktpulsfolge (TP) länger als die erste Taktphase (TH) der folgenden Taktperioden und kürzer als eine zum Erreichen der maximalen Differenzspannung (UDmax) notwendige Zeitdauer einzustellen.

2. Vorrichtung (30) nach Anspruch 1, wobei der Taktgenerator (44) weiter umfasst
- ein Register (48), in dem die Dauer der ersten Taktphase (TH1) speicherbar ist,
- wenigstens ein weiteres Register (49), in dem eine Information über die regulären Taktpulse der Taktpulsfolge (TP) speicherbar ist und
- eine Takt-Ausgabeeinheit (46), die in Folge eines Startbefehls (START) aus den in den Registern (48, 49) gespeicherten Informationen die Taktimpulsfolge (TP) ausgibt.

3. Vorrichtung (30) nach Anspruch 1, wobei der Taktgenerator (44) weiter umfasst
- ein Register (48), in dem eine Leitungslänge (L) speicherbar ist,
- wenigstens ein weiteres Register (49), in dem eine Information über die regulären Taktpulse der Taktpulsfolge (TP) speicherbar ist und
- eine Takt-Ausgabeeinheit (46), die, basierend auf der Leitungslänge (L) und der Information über die regulären Taktpulse der Taktpulsfolge (TP) die Dauer der ersten Taktphase (TH1) ermittelt und in Folge eines Startbefehls (START) die Taktimpulsfolge (TP) ausgibt.

4. Vorrichtung (30) nach Anspruch 1, wobei der Taktgenerator (44) weiter umfasst
- ein Register (48), in dem eine Konstante (K) speicherbar ist,
- wenigstens ein weiteres Register (49), in dem eine Information über die regulären Taktpulse der Taktpulsfolge (TP) speicherbar ist und
- eine Takt-Ausgabeeinheit (46), die, basierend auf der der Information über die regulären Taktpulse der Taktpulsfolge (TP) und der Konstante (K) als Multiplikator, die Dauer der ersten Taktphase (TH1) ermittelt und in Folge eines Startbefehls (START) die Taktimpulsfolge (TP) ausgibt.

5. Vorrichtung (30) nach einem der vorhergehenden Ansprüche, wobei das Datensignal (DT) bidirektional ausgeführt ist und ein Daten-Sendebaustein (52) vorgesehen ist, der das auszugebende Datensignal (DT) in eine differentielles Datensignal (D+, D-) wandelt und der Datencontroller (42) ein Datenrichtungssignal (TR) zur Einstellung der Datenrichtung des differentiellen Datenkanals (62) gemäß eines Schnittstellenprotokolls generiert.

6. Verfahren zur synchron-seriellen Datenübertragung über einen differentiellen Datenkanal (62) und einen differentiellen Taktkanal (60) mit einer Vorrichtung (30), aufweisend einen Schnittstellencontroller (40) mit einem Taktgenerator (44) und einem Datencontroller (42), sowie einen Takt-Sendebaustein (50) und einen Daten-Empfängerbaustein (54), wobei
- vom Taktgenerator (44) ein Sendetaktsignal (CLK_S) erzeugt wird, das während eines Datenübertragungszyklus eine Taktpulsfolge (TP) mit einer Periodendauer (T) umfasst,
- das Sendetaktsignal (CLK_S) dem Takt-Sendebaustein (50) zugeführt wird, der es zur Ausgabe über den Taktkanal (60) in ein differentielles Taktsignal (C+, C-) wandelt,
- ein über den differentiellen Datenkanal (62) eintreffendes differentielles Datensignal (D+, D-) dem Daten-Empfängerbaustein (54) zugeführt wird, der es in ein Datensignal (DT) wandelt und dem Datencontroller (42) zuführt,
- das Sendetaktsignal (CLK_S) dem Datencontroller (42) zur Synchronisation des Einlesens des Datensignals (DT) zugeführt wird,
**dadurch gekennzeichnet, dass** der Taktgenerator (44) geeignet ausgestaltet ist, bei Datenübertragungszyklen in einem dynamischen Betriebszustand (DYN), bei dem die größte auftretende Differenzspannung des differentiellen Taktsignals (C+, C-) kleiner ist als die maximale Differenzspannung (UDmax) des Takt-Sendebausteins (50), die Dauer der ersten Taktphase (TH1) der ersten Taktperiode (T1) der Taktpulsfolge (TP) länger als die erste Taktphase (TH) der folgenden Taktperioden und kürzer als eine zum Erreichen der maximalen Differenzspannung (UDmax) notwendige Zeitdauer einzustellen.

7. Verfahren nach Anspruch 6, wobei der Taktgenerator (44) weiter umfasst
- ein Register (48), in dem die Dauer der ersten Taktphase (TH1) gespeichert wird,
- wenigstens ein weiteres Register (49), in dem eine Information über die regulären Taktpulse der Taktpulsfolge (TP) gespeichert wird und
- eine Takt-Ausgabeeinheit (46), die in Folge eines Startbefehls (START) aus den in den Registern (48, 49) gespeicherten Informationen die Taktimpulsfolge (TP) ausgibt.

8. Verfahren nach Anspruch 6, wobei der Taktgenerator (44) weiter umfasst
- ein Register (48), in dem eine Leitungslänge (L) gespeichert wird,
- wenigstens ein weiteres Register (49), in dem eine Information über die regulären Taktpulse der Taktpulsfolge (TP) gespeichert wird und
- eine Takt-Ausgabeeinheit (46), die, basierend auf der Leitungslänge (L) und der Information über die regulären Taktpulse der Taktpulsfolge (TP) die Dauer der ersten Taktphase (TH1) ermittelt und in Folge eines Startbefehls (START) die Taktimpulsfolge (TP) ausgibt.

9. Verfahren nach Anspruch 6, wobei der Taktgenerator (44) weiter umfasst
- ein Register (48), in dem eine Konstante (K) gespeichert wird,
- wenigstens ein weiteres Register (49), in dem eine Information über die regulären Taktpulse der Taktpulsfolge (TP) gespeichert wird und
- eine Takt-Ausgabeeinheit (46), die, basierend auf der der Information über die regulären Taktpulse der Taktpulsfolge (TP) und der Konstante (K) als Multiplikator, die Dauer der ersten Taktphase (TH1) ermittelt und in Folge eines Startbefehls (START) die Taktimpulsfolge (TP) ausgibt.

10. Verfahren nach einem der Ansprüche 6 bis 9, wobei das Datensignal (DT) bidirektional ausgeführt ist und ein Daten-Sendebaustein (52) vorgesehen ist, der das auszugebende Datensignal (DT) in eine differentielles Datensignal (D+, D-) wandelt und vom Datencontroller (42) ein Datenrichtungssignal (TR) zur Einstellung der Datenrichtung des differentiellen Datenkanals (62) gemäß eines Schnittstellenprotokolls generiert wird.

11. Folgeelektronik mit einer Vorrichtung (30), nach einem der Ansprüche 1 bis 5, weiter aufweisend eine Steuerungseinheit (20), die mit dem Schnittstellencontroller (40) der Vorrichtung (30) über eine interne Schnittstelle (25) verbunden ist.

## Claims

1. Device (30) for synchronous serial data transmission via a differential data channel (62) and a differential clock channel (60), having an interface controller (40) with a clock generator (44) and a data controller (42), and a clock transmission module (50) and a data receiver module (54), wherein
- a transmission clock signal (CLK_S), which comprises a clock pulse sequence (TP) with a period duration (T) during a data transmission cycle, is able to be produced by the clock generator (44),
- the transmission clock signal (CLK_S) is supplied to the clock transmission module (50), which converts said signal to a differential clock signal (C+, C-) for output via the clock channel (60),
- a differential data signal (D+, D-) arriving via the differential data channel (62) is supplied to the data receiver module (54) that converts said signal to a data signal (DT) and supplies same to the data controller (42),
- the transmission clock signal (CLK_S) is supplied to the data controller (42) to synchronize the reading-in of the data signal (DT),
**characterized in that** the clock generator (44) is suitably designed, in the case of data transmission cycles in a dynamic operating state (DYN), in which the greatest occurring differential voltage of the differential clock signal (C+, C-) is lower than the maximum differential voltage (UDmax) of the clock transmission module (50), to set the duration of the first clock phase (TH1) of the first clock period (T1) of the clock pulse sequence (TP) to be longer than the first clock phase (TH) of the following clock periods and shorter than a time duration necessary for reaching the maximum differential voltage (UDmax).

2. Device (30) according to Claim 1, wherein the clock generator (44) also comprises
- a register (48), in which the duration of the first clock phase (TH1) is able to be stored,
- at least one further register (49), in which information regarding the regular clock pulses of the clock pulse sequence (TP) is able to be stored, and
- a clock output unit (46) that outputs the clock pulse sequence (TP) from the information stored in the registers (48, 49) following a start command (START).

3. Device (30) according to Claim 1, wherein the clock generator (44) also comprises
- a register (48), in which a line length (L) is able to be stored,
- at least one further register (49), in which information regarding the regular clock pulses of the clock pulse sequence (TP) is able to be stored, and
- a clock output unit (46) that ascertains the duration of the first clock phase (TH1) on the basis of the line length (L) and the information regarding the regular clock pulses of the clock pulse sequence (TP), and outputs the clock pulse sequence (TP) following a start command (START).

4. Device (30) according to Claim 1, wherein the clock generator (44) also comprises
- a register (48), in which a constant (K) is able to be stored,
- at least one further register (49), in which information regarding the regular clock pulses of the clock pulse sequence (TP) is able to be stored, and
- a clock output unit (46) that ascertains the duration of the first clock phase (TH1) on the basis of the information regarding the regular clock pulses of the clock pulse sequence (TP) and the constant (K) as multiplier, and outputs the clock pulse sequence (TP) following a start command (START).

5. Device (30) according to one of the preceding claims, wherein the data signal (DT) is of bidirectional design and a data transmission module (52) is provided that converts the data signal (DT) to be output to a differential data signal (D+, D-) and the data controller (42) generates a data direction signal (TR) for setting the data direction of the differential data channel (62) in accordance with an interface protocol.

6. Method for synchronous serial data transmission via a differential data channel (62) and a differential clock channel (60) using a device (30), having an interface controller (40) with a clock generator (44) and a data controller (42), and a clock transmission module (50) and a data receiver module (54), wherein
- a transmission clock signal (CLK_S), which comprises a clock pulse sequence (TP) with a period duration (T) during a data transmission cycle, is produced by the clock generator (44),
- the transmission clock signal (CLK_S) is supplied to the clock transmission module (50), which converts said signal to a differential clock signal (C+, C-) for output via the clock channel (60),
- a differential data signal (D+, D-) arriving via the differential data channel (62) is supplied to the data receiver module (54) that converts said signal to a data signal (DT) and supplies same to the data controller (42),
- the transmission clock signal (CLK_S) is supplied to the data controller (42) to synchronize the reading-in of the data signal (DT),
**characterized in that** the clock generator (44) is suitably designed, in the case of data transmission cycles in a dynamic operating state (DYN), in which the greatest occurring differential voltage of the differential clock signal (C+, C-) is lower than the maximum differential voltage (UDmax) of the clock transmission module (50), to set the duration of the first clock phase (TH1) of the first clock period (T1) of the clock pulse sequence (TP) to be longer than the first clock phase (TH) of the following clock periods and shorter than a time duration necessary for reaching the maximum differential voltage (UDmax).

7. Method according to Claim 6, wherein the clock generator (44) also comprises
- a register (48), in which the duration of the first clock phase (TH1) is stored,
- at least one further register (49), in which information regarding the regular clock pulses of the clock pulse sequence (TP) is stored, and
- a clock output unit (46) that outputs the clock pulse sequence (TP) from the information stored in the registers (48, 49) following a start command (START).

8. Method according to Claim 6, wherein the clock generator (44) also comprises
- a register (48), in which a line length (L) is stored,
- at least one further register (49), in which information regarding the regular clock pulses of the clock pulse sequence (TP) is stored, and
- a clock output unit (46) that ascertains the duration of the first clock phase (TH1) on the basis of the line length (L) and the information regarding the regular clock pulses of the clock pulse sequence (TP), and outputs the clock pulse sequence (TP) following a start command (START).

9. Method according to Claim 6, wherein the clock generator (44) also comprises
- a register (48), in which a constant (K) is stored,
- at least one further register (49), in which information regarding the regular clock pulses of the clock pulse sequence (TP) is stored, and
- a clock output unit (46) that ascertains the duration of the first clock phase (TH1) on the basis of the information regarding the regular clock pulses of the clock pulse sequence (TP) and the constant (K) as multiplier, and outputs the clock pulse sequence (TP) following a start command (START).

10. Method according to one of Claims 6 to 9, wherein the data signal (DT) is of bidirectional design and a data transmission module (52) is provided that converts the data signal (DT) to be output to a differential data signal (D+, D-) and a data direction signal (TR) for setting the data direction of the differential data channel (62) in accordance with an interface protocol is generated by the data controller (42).

11. Downstream electronics comprising a device (30) according to one of Claims 1 to 5, also having a control unit (20) that is connected to the interface controller (40) of the device (30) via an internal interface (25).

## Revendications

1. Dispositif (30) de transmission de données série synchrone par un canal de données différentiel (62) et un canal d'horloge différentiel (60), présentant un contrôleur d'interface (40) muni d'un générateur d'horloge (44) et d'un contrôleur de données (42), ainsi qu'un composant émetteur d'horloge (50) et un composant récepteur de données (54), dans lequel
- le générateur d'horloge (44) permet de générer un signal d'horloge d'émission (CLK_S) qui comprend pendant un cycle de transmission de données un train d'impulsions d'horloge (TP) ayant une durée de période (T),
- le signal d'horloge d'émission (CLK_S) est amené au composant émetteur d'horloge (50) qui le convertit en un signal d'horloge différentiel (C+, C-) à sortir par le canal d'horloge (60),
- un signal de données différentiel (D+, D-) arrivant par le canal de données différentiel (62) est amené au composant récepteur de données (54) qui le convertit en un signal de données (DT) et l'amène au contrôleur de données (42),
- le signal d'horloge d'émission (CLK_S) est amené au contrôleur de données (42) pour synchroniser la lecture du signal de données (DT),
**caractérisé en ce que** le générateur d'horloge (44) est configuré de manière appropriée pour régler pour des cycles de transmission de données dans un état de fonctionnement dynamique (DYN), dans lequel la plus grande tension différentielle apparente du signal d'horloge différentiel (C+, C-) est inférieure à la tension différentielle maximale (UDmax) du composant émetteur d'horloge (50), la durée de la première phase d'horloge (TH1) de la première période d'horloge (T1) du train d'impulsions d'horloge (TP) pour qu'elle soit plus longue que la première phase d'horloge (TH) des périodes d'horloge suivantes et plus courte qu'une durée nécessaire pour atteindre la tension différentielle maximale (UDmax).

2. Dispositif (30) selon la revendication 1, dans lequel le générateur d'horloge (44) comprend en outre
- un registre (48) qui permet de stocker la durée de la première phase d'horloge (TH1),
- au moins un autre registre (49) qui permet de stocker une information concernant les impulsions d'horloge régulières du train d'impulsions d'horloge (TP), et
- une unité de sortie d'horloge (46) qui sort à la suite d'un ordre de démarrage (START) le train d'impulsions d'horloge (TP) à partir des informations stockées dans les registres (48, 49).

3. Dispositif (30) selon la revendication 1, dans lequel le générateur d'horloge (44) comprend en outre
- un registre (48) qui permet de stocker une longueur de ligne (L),
- au moins un autre registre (49) qui permet de stocker une information concernant les impulsions d'horloge régulières du train d'impulsions d'horloge (TP), et
- une unité de sortie d'horloge (46) qui détermine la durée de la première phase d'horloge (TH1) sur la base de la longueur de ligne (L) et de l'information concernant les impulsions d'horloge régulières du train d'impulsions d'horloge (TP) et sort le train d'impulsions d'horloge (TP) à la suite d'un ordre de démarrage (START).

4. Dispositif (30) selon la revendication 1, dans lequel le générateur d'horloge (44) comprend en outre
- un registre (48) qui permet de stocker une constante (K),
- au moins un autre registre (49) qui permet de stocker une information concernant les impulsions d'horloge régulières du train d'impulsions d'horloge (TP), et
- une unité de sortie d'horloge (46) qui détermine la durée de la première phase d'horloge (TH1) sur la base de l'information concernant les impulsions d'horloge régulières du train d'impulsions d'horloge (TP) et de la constante (K) comme multiplicateur et sort le train d'impulsions d'horloge (TP) à la suite d'un ordre de démarrage (START).

5. Dispositif (30) selon l'une quelconque des revendications précédentes, dans lequel le signal de données (DT) est réalisé de manière bidirectionnelle, et un composant émetteur de données (52) est prévu qui convertit le signal de données (DT) à sortir en un signal de données différentiel (D+, D-), et le contrôleur de données (42) génère un signal du sens des données (TR) pour régler le sens des données du canal de données différentiel (62) selon un protocole d'interface.

6. Procédé de transmission de données série synchrone par un canal de données différentiel (62) et un canal d'horloge différentiel (60) à l'aide d'un dispositif (30), présentant un contrôleur d'interface (40) muni d'un générateur d'horloge (44) et d'un contrôleur de données (42), ainsi qu'un composant émetteur d'horloge (50) et un composant récepteur de données (54), dans lequel
- le générateur d'horloge (44) génère un signal d'horloge d'émission (CLK_S) qui comprend pendant un cycle de transmission de données un train d'impulsions d'horloge (TP) ayant une durée de période (T),
- le signal d'horloge d'émission (CLK_S) est amené au composant émetteur d'horloge (50) qui le convertit en un signal d'horloge différentiel (C+, C-) à sortir par le canal d'horloge (60),
- un signal de données différentiel (D+, D-) arrivant par le canal de données différentiel (62) est amené au composant récepteur de données (54) qui le convertit en un signal de données (DT) et l'amène au contrôleur de données (42),
- le signal d'horloge d'émission (CLK_S) est amené au contrôleur de données (42) pour synchroniser la lecture du signal de données (DT),
**caractérisé en ce que** le générateur d'horloge (44) est configuré de manière appropriée pour régler pour des cycles de transmission de données dans un état de fonctionnement dynamique (DYN), dans lequel la plus grande tension différentielle apparente du signal d'horloge différentiel (C+, C-) est inférieure à la tension différentielle maximale (UDmax) du composant émetteur d'horloge (50), la durée de la première phase d'horloge (TH1) de la première période d'horloge (T1) du train d'impulsions d'horloge (TP) pour qu'elle soit plus longue que la première phase d'horloge (TH) des périodes d'horloge suivantes et plus courte qu'une durée nécessaire pour atteindre la tension différentielle maximale (UDmax).

7. Procédé selon la revendication 6, dans lequel le générateur d'horloge (44) comprend en outre
- un registre (48) dans lequel est stockée la durée de la première phase d'horloge (TH1),
- au moins un autre registre (49) dans lequel est stockée une information concernant les impulsions d'horloge régulières du train d'impulsions d'horloge (TP), et
- une unité de sortie d'horloge (46) qui sort à la suite d'un ordre de démarrage (START) le train d'impulsions d'horloge (TP) à partir des informations stockées dans les registres (48, 49).

8. Procédé selon la revendication 6, dans lequel le générateur d'horloge (44) comprend en outre
- un registre (48) dans lequel est stockée une longueur de ligne (L),
- au moins un autre registre (49) dans lequel est stockée une information concernant les impulsions d'horloge régulières du train d'impulsions d'horloge (TP), et
- une unité de sortie d'horloge (46) qui détermine la durée de la première phase d'horloge (TH1) sur la base de la longueur de ligne (L) et de l'information concernant les impulsions d'horloge régulières du train d'impulsions d'horloge (TP), et sort le train d'impulsions d'horloge (TP) à la suite d'un ordre de démarrage (START).

9. Procédé selon la revendication 6, dans lequel le générateur d'horloge (44) comprend en outre
- un registre (48) dans lequel est stockée une constante (K),
- au moins un autre registre (49) dans lequel est stockée une information concernant les impulsions d'horloge régulières du train d'impulsions d'horloge (TP), et
- une unité de sortie d'horloge (46) qui détermine la durée de la première phase d'horloge (TH1) sur la base de l'information concernant les impulsions d'horloge régulières du train d'impulsions d'horloge (TP) et de la constante (K) comme multiplicateur, et sort le train d'impulsions d'horloge (TP) à la suite d'un ordre de démarrage (START).

10. Procédé selon l'une quelconque des revendications 6 à 9, dans lequel le signal de données (DT) est réalisé de manière bidirectionnelle, et un composant émetteur de données (52) est prévu qui convertit le signal de données (DT) à sortir en un signal de données différentiel (D+, D-), et le contrôleur de données (42) génère un signal du sens des données (TR) pour régler le sens des données du canal de données différentiel (62) selon un protocole d'interface.

11. Electronique séquentielle, comprenant un dispositif (30) selon l'une quelconque des revendications 1 à 5, présentant en outre une unité de commande (20) qui est reliée au contrôleur d'interface (40) du dispositif (30) par l'intermédiaire d'une interface interne (25).
